(19) **Europäisches Patentamt / European Patent Office / Office européen des brevets**

(11) **EP 1 805 815 B1**

(12) ## EUROPÄISCHE PATENTSCHRIFT

(45) Veröffentlichungstag und Bekanntmachung des Hinweises auf die Patenterteilung:
**12.06.2019 Patentblatt 2019/24**

(21) Anmeldenummer: **05810075.1**

(22) Anmeldetag: **20.10.2005**

(51) Int Cl.:
***H01L 33/00*** *(2010.01)*

(86) Internationale Anmeldenummer:
**PCT/DE2005/001874**

(87) Internationale Veröffentlichungsnummer:
**WO 2006/045277 (04.05.2006 Gazette 2006/18)**

(54) **BELEUCHTUNGSEINRICHTUNG, KFZ-SCHEINWERFER UND VERFAHREN ZUR HERSTELLUNG EINER BELEUCTUNGSEINRICHTUNG**

LIGHTING DEVICE, AUTOMOTIVE HEADLIGHTS AND METHOD FOR PRODUCING A LIGHTING DEVICE

DISPOSITIF D'ECLAIRAGE, PHARES DE VEHICULES AUTOMOBILES ET PROCEDE DE PRODUCTION D'UN DISPOSITIF D'ECLAIRAGE

(84) Benannte Vertragsstaaten:
**DE**

(30) Priorität: **29.10.2004 DE 102004052687**
**22.11.2004 DE 102004056252**

(43) Veröffentlichungstag der Anmeldung:
**11.07.2007 Patentblatt 2007/28**

(73) Patentinhaber: **OSRAM Opto Semiconductors GmbH**
**93055 Regensburg (DE)**

(72) Erfinder:
• **ENGL, Moritz**
**93055 Regensburg (DE)**
• **GRÖTSCH, Stefan**
**93077 Lengfeld/Bad Abbach (DE)**
• **HOFMANN, Markus**
**93077 Bad Abbach (DE)**

• **HUBER, Rainer**
**93080 Pentling (DE)**
• **LANG, Kurt-Jürgen**
**94209 Regen (DE)**
• **REILL, Joachim**
**93197 Zeitlarn (DE)**
• **SAILER, Michael**
**93098 Wolfskofen (DE)**
• **WANNINGER, Mario**
**93055 Harting (DE)**

(74) Vertreter: **Epping - Hermann - Fischer Patentanwaltsgesellschaft mbH**
**Schloßschmidstraße 5**
**80639 München (DE)**

(56) Entgegenhaltungen:
**WO-A-99/44087       WO-A-2004/088200**
**US-A1- 2002 094 175   US-A1- 2003 156 416**
**US-A1- 2004 184 737**

EP 1 805 815 B1

**Beschreibung**

Die Erfindung betrifft einen Kfz-Scheinwerfer aufweisend zumindest eine Beleuchtungseinrichtung. Weiter betrifft die Erfindung ein Verfahren zur Herstellung eines Kfz-Scheinwerfers.

In der Druckschrift US 2004/0184737 ist beispielsweise ein optisches System zur Datenübertragung beschrieben, das eine optische Anordnung mit einem Substrat, auf welchem mindestens ein optisches Bauelement, beispielsweise eine Leuchtdiode oder eine Photodiode, angeordnet ist, und eine optische Komponente, beispielsweise einen Wellenleiter oder eine Faser, aufweist, wobei die optische Komponente relativ zur optischen Anordnung mittels Führungsstiften justiert ist. Die Führungsstifte greifen in Vertiefungen ein, die im Substrat und der optischen Komponente eingebracht sind.

Ferner ist in der Druckschrift US 2003/0156416 A1 eine Leuchtvorrichtung beschrieben, die einen Anschlussträger, auf welchem mehrere Leuchtdioden angeordnet sind, und einen Reflektor aufweist, welcher den Leuchtdioden ausgehend vom Anschlussträger nachgeordnet ist. In den Reflektor kann eine Sammellinse mittels Befestigungsfüßen eingeklemmt werden. Der Anschlussträger ist auf einer Wärmesenke angeordnet und mittels Befestigungselementen an der Wärmesenke befestigt. Der Reflektor ist mittels derselben Befestigungselemente an der Wärmesenke befestigt, wobei die Befestigungselemente durch Löcher des Anschlussträgers hindurch in Steckvertiefungen am Reflektor eingesteckt sind.

Es ist Aufgabe der vorliegenden Erfindung, einen Kfz-Scheinwerfer mit einer Beleuchtungseinrichtung anzugeben, die besonders vielseitig einsetzbar ist. Weiter ist es Aufgabe der vorliegenden Erfindung, ein Verfahren zur Herstellung eines solchen Kfz-Scheinwerfers anzugeben.

Die Aufgaben werden gelöst durch eine einen Kfz-Scheinwerfer gemäß Patentanspruch 1 sowie ein Verfahren zur Herstellung eines Kfz-Scheinwerfers gemäß Patentanspruch 12. Vorteilhafte Ausgestaltungen der Erfindung sind Gegenstand von Unteransprüchen.

Es wird ein Kfz-Scheinwerfer aufweisend zumindest eine Beleuchtungseinrichtung angegeben.

Die Beleuchtungseinrichtung weist zumindest eine Leuchtdiode auf. Zum Beispiel weist die Beleuchtungseinrichtung mehrere Leuchtdioden auf. Gemäß zumindest einer Ausführungsform der Beleuchtungseinrichtung ist es möglich, dass jeder Leuchtdiode genau ein optisches Element eineindeutig zugeordnet ist. Das heißt, das optische Element beeinflusst hauptsächlich das von dieser Leuchtdiode emittierte Licht.

Gemäß wenigstens einer Ausführungsform der Beleuchtungseinrichtung ist mehreren Leuchtdioden ein gemeinsames optisches Element nachgeordnet. Das heißt, das optische Element beeinflusst das Licht von mehreren dem optischen Element zugeordneten Leuchtdioden. Insbesondere ist es möglich, dass allen Leuchtdioden der Beleuchtungseinrichtung genau ein gemeinsames optisches Element nachgeordnet ist.

Leuchtdiode und optisches Element sind dabei auf einen gemeinsamen Träger montiert. Sowohl Leuchtdiode als auch optisches Element sind mittels je wenigstens eines Passstifts mit dem Träger verbunden. Leuchtdiode und optisches Element sind mittels dieser Passstifte jeweils zum Träger und damit zueinander justiert.

In zumindest einer Ausführungsform der Beleuchtungseinrichtung ist zumindest ein Teil des optischen Elements durch eine Faseroptik gebildet. Das heißt, zumindest ein Teil des optischen Elements enthält einen Lichtleiter. Bevorzugt koppelt das Licht einer Leuchtdiode in wenigstens eine Faser der Faseroptik ein. Enthält die Leuchtdiode z. B. mehrere Leuchtdiodenchips, dann koppelt das Licht eines jeden Leuchtdiodenchips in genau eine Faser der Faseroptik ein. Dem Teil der Faseroptik, durch den die von den Leuchtdioden erzeugte elektromagnetische Strahlung die Optik wieder verlässt, kann beispielsweise ein zusätzliches optisches Element nachgeordnet sein. Das zusätzliche optische Element kann beispielsweise durch eine refraktive oder diffraktive Linse gebildet sein.

Zum Beispiel weist der Passstift zwei Grundflächen auf, die durch eine Mantelfläche miteinander verbunden sind. Bevorzugt weisen die Grundflächen des Passstifts gleiche Form und Größe auf. Die Mantelfläche ist bevorzugt glatt ausgebildet und verbindet die beiden Grundflächen entlang einer Geraden. Bevorzugt steht die Mantelfläche auf den beiden Ebenen, die durch die beiden Grundflächen des Passstifts aufgespannt sind, senkrecht. Beispielsweise weist der Passstift eine der folgenden Formen auf: Zylinder, Quader.

Zum Beispiel greift der Passstift an zumindest einem seiner Enden in eine Ausnehmung. Das heißt, die Ausnehmung ist zur Aufnahme des Passstifts geeignet. Bevorzugt weist die Ausnehmung eine Umrandung in der gleichen Form wie die Grundfläche des Endes des Passstifts auf, das in die Ausnehmung greift. Ist der Passstift beispielsweise zylinderförmig, so ist die Ausnehmung bevorzugt durch eine kreisförmige Bohrung gegeben.

Die Öffnung der Ausnehmung ist bevorzugt derart dimensioniert, dass der Passstift bündig in die Ausnehmung greift. Beispielsweise passt der Passstift formschlüssig in die Ausnehmung. Der Passstift ist dann zum Beispiel in die Ausnehmung steckbar.

Es ist aber auch möglich, dass die Öffnung der Ausnehmung geringfügig enger ausgebildet ist, als die Grundfläche des Endes des Passstifts, das in die Ausnehmung greift. Der Passstift kann dann in die Ausnehmung gepresst werden. Mittels dieser Presspassung erfolgt dann zugleich eine mechanische Befestigung. Das heißt, das optische Element kann mittels des Passstiftes mechanisch mit dem Träger verbunden sein.

Die Leuchtdiode ist auf dem Träger angeordnet. Dabei sind die Leuchtdiode und der Träger mittels wenigstens eines Passstifts zueinander justiert. Sind mehrere Leuchtdioden auf den Träger angeordnet, können die Leuchtdioden mittels Passstiften zum Träger und damit auch zueinander justiert sein.

Gemäß zumindest einer Ausführungsform der Beleuchtungseinrichtung weist die Leuchtdiode wenigstens einen Leuchtdiodenchip auf, dem eine Leuchtdiodenoptik nachgeordnet ist.

Gemäß zumindest einer Ausführungsform der Beleuchtungseinrichtung ist die Leuchtdiodenoptik geeignet, die Divergenz des vom Leuchtdiodenchip emittierten Lichts zu verringern. Das heißt, das von den Leuchtdiodenchips emittierte Licht wird beispielsweise bei Durchtritt durch die Leuchtdiodenoptik derart beeinflusst, dass seine Divergenz nach dem Austritt geringer ist als vor dem Eintritt in die Leuchtdiodenoptik.

In zumindest einer Ausführungsform der Beleuchtungseinrichtung ist die Leuchtdiodenoptik ein nicht abbildender optischer Konzentrator. Dabei ist die Leuchtdiodenoptik bevorzugt derart der Strahlungsauskoppelfläche wenigstens eines Leuchtdiodenchips nachgeordnet, dass die Strahlungseintrittsöffnung des optischen Elements die eigentliche Strahlungsaustrittsöffnung des Konzentrators ist. Das heißt, die Leuchtdiodenoptik verjüngt sich in Richtung der Leuchtdiodenchips. Auf diese Weise verlässt durch die Strahlungseintrittsöffnung in die Leuchtdiodenoptik tretende elektromagnetische Strahlung den Konzentrator mit verringerter Divergenz durch die Strahlungsaustrittsöffnung.

Die Leuchtdiodenoptik kann zumindest teilweise nach Art eines der folgenden optischen Elemente gebildet sein: zusammengesetzter parabolischer Konzentrator (CPC - Compound Parabolic Concentrator), zusammengesetzter elliptischer Konzentrator (CEC - Compound Ellyptic Concentrator), zusammengesetzter hyperbolischer Konzentrator (CHC - Compound Hyperbolic Concentrator).

Die Leuchtdiodenoptik kann reflektierende Seitenwände aufweisen, die geeignet sind, zumindest einen Teil der vom Leuchtdiodenchip emittierten elektromagnetischen Strahlung zu reflektieren. Die Seitenwände sind dann zumindest teilweise nach Art eines der oben genannten optischen Elemente gebildet.

Gemäß wenigstens einer Ausführungsform der Beleuchtungseinrichtung weist der nicht abbildende optische Konzentrator Seitenwände auf, die die Strahlungseintrittsöffnung mit der Strahlungsaustrittsöffnung der Leuchtdiodenoptik verbinden und dabei derart ausgebildet sind, dass auf den Seitenwänden verlaufende Verbindungslinien zwischen der Strahlungseintrittsöffnung und der Strahlungsaustrittsöffnung im Wesentlichen gerade verlaufen. Die Seitenwände bilden beispielsweise die Form eines Pyramiden- oder Kegelstumpfes.

Die Leuchtdiodenoptik kann in diesem Fall ein aus einem dielektrischen Material bestehender Vollkörper sein. Die durch die Strahlungseintrittsöffnung in die Leuchtdiodenoptik tretende elektromagnetische Strahlung wird dann bevorzugt an den seitlichen Grenzflächen des Vollkörpers zum umgebenden Medium reflektiert.

Zum Beispiel ist jedem Leuchtdiodenchip genau eine Leuchtdiodenoptik zugeordnet. Die Strahlungseintrittsöffnung des optischen Elements ist bevorzugt der Strahlungsauskoppelfläche des Leuchtdiodenchips in einer Hauptabstrahlrichtung des Leuchtdiodenchips nachgeordnet.

Es ist aber auch möglich, dass mehrere Leuchtdiodenchips einer gemeinsamen Leuchtdiodenoptik zugeordnet sind. Die Leuchtdiodenchips können dazu beispielsweise entlang wenigstens einer Geraden angeordnet sein. Die Strahlungseintrittsöffnung des optischen Elements ist dann der Gesamtfläche der Strahlungsauskoppelflächen der einzelnen Leuchtdiodenchips in einer Hauptabstrahlrichtung der Leuchtdiodenchips nachgeordnet.

Zum Beispiel weist die Strahlungseintrittsöffnung der Leuchtdiodenoptik eine Querschnittfläche auf, die maximal zwei Mal so groß ist wie die Gesamtstrahlungsauskoppelfläche der dem optischen Element zugeordneten Leuchtdiodenchips. Die Gesamtstrahlungsauskoppelfläche ist durch die Summe der Strahlungsauskoppelflächen der einzelnen, der Leuchtdiodenoptik zugeordneten Leuchtdiodenchips gegeben. Zum Beispiel ist die Fläche der Strahlungseintrittsöffnung maximal 1,5, besonders bevorzugt maximal 1,25 Mal so groß wie die Gesamtstrahlungsauskoppelfläche der der Leuchtdiodenoptik zugeordneten Leuchtdiodenchips.

Eine derart kleine Strahlungseintrittsöffnung erlaubt es, den Raumwinkel, in den die elektromagnetische Strahlung emittiert wird, möglichst nahe an der Strahlungsauskoppelfläche des Leuchtdiodenchips zu verkleinern. Dort ist die Querschnittsfläche des vom Leuchtdiodenchip emittierten Strahlenkegels besonders klein. Dies ermöglicht die Konstruktion von Bauelementen mit optimiertem Etendue. Das heißt, eine möglichst hohe Strahlungsstärke wird auf eine möglichst kleine Fläche projiziert. Das Etendue ist eine Erhaltungsgröße der Optik. Sie ist durch das Produkt aus Flächeninhalt einer Lichtquelle und Raumwinkel, in den die Lichtquelle abstrahlt, gebildet.

Zum Beispiel ist zwischen der Strahlungsauskoppelfläche des Leuchtdiodenchips und der Strahlungseintrittsöffnung der Leuchtdiodenoptik ein Spalt, beispielsweise ein Luftspalt, angeordnet. Dadurch ist erreicht, dass besonders divergente Strahlung nicht in die Leuchtdiodenoptik gelangt, sondern durch den Spalt vor dem Eintritt in die Leuchtdiodenoptik seitlich austreten kann. Damit lässt sich die Divergenz der vom optischen Element emittierten elektromagnetischen Strahlung weiter verringern.

Anstelle eines Spalts ist es zudem möglich, dass beispielsweise Seitenwände, die der Strahlungsauskoppelfläche des Leuchtdiodenchips nachgeordnet sind, nahe an der Strahlungseintrittsöffnung des optischen Elements absorbierend oder für elektromagnetische Strahlung transparent ausgebildet sind. Auf diese Weise kann erreicht sein, dass der hoch divergente Anteil der vom Leuchtdiodenchip emittierten elektromagnetischen Strahlung nicht in das optische Element tritt.

Beispielsweise ist der Strahlungsaustrittsöffnung des optischen Elements ein zusätzliches optisches Element in Hauptabstrahlrichtung nachgeordnet. Bei dem zusätzlichen optischen Element handelt es sich bevorzugt um eine Licht brechende oder Licht beugende Optik, mit der eine weitere Verringerung der Divergenz der durch das zusätzliche optische Element tretenden Strahlung erreicht werden kann.

Bevorzugt verringert die Leuchtdiodenoptik die Divergenz eines durch die Strahlungseintrittsöffnung tretenden Strahlkegels zumindest in einer Raumrichtung derart, dass der Strahlkegel beim Austritt durch die Strahlungsaustrittsöffnung einen Öffnungswinkel zwischen 0 und 70°, bevorzugt zwischen 0 und 20°, besonders bevorzugt zwischen 0 und 10° zu einer Längsmittelachse des optischen Elements aufweist, die senkrecht auf der Strahlungsauskoppelfläche eines der Leuchtdiodenoptik zugeordneten Leuchtdiodenchips steht.

Beispielsweise weist die Leuchtdiode ein Lumineszenz-Konversionsmaterial auf, das der Strahlungsauskoppelfläche wenigstens einer der Leuchtdiodenchips nachgeordnet ist. Bevorzugt ist ein Lumineszenz-Konversionsmaterial der Strahlungsauskoppelfläche eines jeden Leuchtdiodenchips der Beleuchtungseinrichtung nachgeordnet.

Das Lumineszenz-Konversionsmaterial ist beispielsweise geeignet, wenigstens einen Teil der vom Leuchtdiodenchip ausgesandten elektromagnetischen Strahlung Wellenlängen zu konvertieren. Bevorzugt mischt sich die vom Leuchtdiodenchip emittierte Strahlung mit dem wellenlängenkonvertierten Anteil zu weißem Licht.

Es ist aber auch möglich, dass die vom Leuchtdiodenchip emittierte elektromagnetische Strahlung im Wesentlichen vollständig durch das Lumineszenz-Konversionsmaterial wellenlängenkonvertiert wird. Beispielsweise kann auf diese Weise vom Leuchtdiodenchip emittierte Strahlung im nicht sichtbaren Spektralbereich zu Strahlung im sichtbaren Spektralbereich umgewandelt werden. Durch Verwendung von beispielsweise zwei verschiedenen Leuchtstoffen im Lumineszenz-Konversionsmaterial kann dann durch Lichtmischung z. B. weißes Licht erzeugt werden. Geeignete Leuchtstoffe zur Wellenlängenkonvertierung sind beispielsweise in der Druckschrift WO98/12757 beschrieben.

Das Lumineszenz-Konversionsmaterial kann einer zumindest teilweise strahlungsdurchlässigen Vergussmasse beigemischt sein. Bevorzugt umgibt die Vergussmasse den Leuchtdiodenchip zumindest teilweise. Die Vergussmasse kann beispielsweise Epoxidund/oder Silikon-Materialien enthalten.

Das Lumineszenz-Konversionsmaterial kann jedoch auch als dünne Schicht direkt auf die Strahlungsauskoppelfläche der einzelnen Leuchtdiodenchips aufgebracht sein.

Zudem ist es möglich, dass das Lumineszenz-Konversionsmaterial zumindest stellenweise in der Leuchtdiodenoptik enthalten ist. So kann das Lumineszenz-Konversionsmaterial etwa als dünne Schicht auf Seitenwände, die der Strahlungsauskoppelfläche des Leuchtdiodenchips nachgeordnet sind, aufgebracht sein. Das Lumineszenz-Konversionsmaterial kann homogen auf den Seitenwänden verteilt sein. Es ist aber auch möglich, dass das Lumineszenz-Konversionsmaterial auf definierte Stellen der Seitenwände aufgebracht ist. Auf diese Weise ist eine besonders definierte Konversion der durch das optische Element tretenden elektromagnetischen Strahlung möglich.

Zum Beispiel ist es auch möglich, dass die Leuchtdiode Leuchtdiodenchips enthält, die Strahlung unterschiedlicher Wellenlänge emittieren. Bevorzugt mischt sich diese Strahlung dann zu weißem Licht. Beispielsweise kann die Leuchtdiode wenigstens einen Leuchtdiodenchip enthalten, der geeignet ist, Licht im roten Spektralbereich zu emittieren, wenigstens einen Leuchtdiodenchip, der geeignet ist, Licht im grünen Spektralbereich zu emittieren und wenigstens einen Leuchtdiodenchip, der geeignet ist, Licht im blauen Spektralbereich zu emittieren. Zur Verbesserung des Farbwiedergabewerts kann die Leuchtdiode zusätzlich Leuchtdiodenchips aufweisen, die geeignet sind, Licht in anderen Spektralbereichen - zum Beispiel im gelben Spektralbereich - zu emittieren.

Zum Beispiel weist wenigstens einer der Leuchtdiodenchips der Leuchtdiode eine Strahlungsauskoppelfläche auf, durch die ein Großteil der vom Leuchtdiodenchip emittierten elektromagnetischen Strahlung ausgekoppelt wird. Besonders bevorzugt tritt die gesamte vom Leuchtdiodechip emittierte Strahlung durch die Strahlungsauskoppelfläche aus.

Die Strahlungsauskoppelfläche ist beispielsweise durch einen Teil der Oberfläche des Leuchtdiodenchips gegeben. Bevorzugt ist die Strahlungsauskoppelfläche durch eine Hauptfläche des Leuchtdiodenchips gegeben, die beispielsweise parallel zu einer Epitaxie-Schichtfolge des Leuchtdiodenchips angeordnet ist, welche geeignet ist, elektromagnetische Strahlung zu erzeugen.

Dazu kann die Epitaxie-Schichtfolge beispielsweise einen pn-Übergang, eine Doppelheterostruktur, eine Einfachquantentopf- oder besonders bevorzugt eine Mehrfach-Quantentopfstruktur aufweisen.

Die Bezeichnung Quantentopfstruktur umfasst im Rahmen der Anmeldung auch jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Bevorzugt handelt es sich bei dem Leuchtdiodenchip um einen Halbleiter-Leuchtdiodenchip, bei dem das Aufwachssubstrat zumindest teilweise entfernt ist und auf dessen dem ursprünglichen Aufwachssubstrat abgewandte Oberfläche ein Trägerelement aufgebracht ist. Das Trägerelement kann verglichen mit einem Aufwachssubstrat relativ frei gewählt werden. Bevorzugt wird ein Trägerelement gewählt, das hinsichtlich seines Temperaturausdehnungskoeffizienten besonders gut an die strahlungserzeugende Epitaxie-Schichtfolge angepasst ist. Weiter kann das Trägerelement ein Material enthalten, das besonders gut wärmeleitend ist.

Solche durch das Entfernen von Aufwachssubstrat hergestellten Leuchtdiodenchips, werden oftmals als Dünnfilm-Leuchtdiodenchips bezeichnet und zeichnen sich bevorzugt durch die folgenden Merkmale aus:

- An einer zur Trägerseite hingewandten ersten Hauptfläche der strahlungserzeugenden Epitaxie-Schichtfolge ist eine reflektierende Schicht oder Schichtenfolge aufgebracht oder ausgebildet, die zumindest einen Teil der in der Epitaxie-Schichtfolge erzeugten elektromagnetischen Strahlung in diese zurück reflektiert.

- Die Epitaxie-Schichtfolge weist bevorzugt eine Dicke von maximal 20 $\mu$m, besonders bevorzugt von maximal 10 $\mu$m auf.

- Weiter enthält die Epitaxie-Schichtfolge bevorzugt mindestens eine Halbleiterschicht mit zumindest einer Fläche, die eine Durchmischungsstruktur aufweist. Im Idealfall führt diese Durchmischungsstruktur zu einer annähernd ergodischen Verteilung des Lichts in der Epitaxie-Schichtfolge, d. h., sie weist ein möglichst ergodisch, stochastisches Streuverhalten auf.

Ein Grundprinzip eines Dünnfilm-Leuchtdiodenchips ist beispielsweise in der Druckschrift I. Schnitzer et al., Appl. Phys. Lett. 63 (16), 18. Oktober 1993, 2174 - 2176 beschrieben.

Zum Beispiel sind alle Leuchtdiodenchips der Beleuchtungseinrichtung Dünnfilm-Leuchtdiodenchips.

Weiter wird ein Verfahren zur Herstellung eines Kfz-Scheinwerfers aufweisend mindestens eine Beleuchtungseinrichtung angegeben.

Mit Hilfe des Verfahrens ist es möglich ein optisches Element und eine Leuchtdiode in vorgebbarer Weise relativ zueinander zu positionieren.

Dazu wird der Passstift zum Beispiel in eine für den Passstift vorgesehene Ausnehmung geschoben oder gepresst. Beispielsweise ist die Leuchtdiode dazu auf einen Träger aufgebracht. Das optische Element, der Träger oder optisches Element und Träger weisen dann eine Ausnehmung auf, die zur Aufnahme eines Passstifts geeignet ist. Dabei ist der Passstift entweder ein integraler Bestandteil des Trägers, des optischen Elements oder ein separates Bauteil. Mittels des Passstifts ist es möglich, optisches Element und Träger relativ zueinander zu positionieren und damit optisches Element und die auf den Träger montierte Leuchtdiode zueinander zu justieren.

Gemäß zumindest einer Ausführungsform des Verfahrens werden eine Leuchtdiode und der Träger mittels eines Passstifts zueinander justiert. Dabei ist es wiederum möglich, dass der Passstift integraler Bestandteil einer der beiden Bauteile ist. Außerdem ist es möglich, dass der Passstift ein separates Bauteil ist, Leuchtdiode und Träger weisen dann Ausnehmungen auf, die zur Aufnahme des Passstifts geeignet sind. Mittels des Verfahrens können Leuchtdiode und Träger relativ zueinander in vorgebbarer Weise positioniert werden. Werden mehrere Leuchtdioden und ein Träger zueinander justiert, so findet zudem mittels des Passstifts eine Justage der Leuchtdioden zueinander statt.

Im Folgenden wird die hier beschriebene Beleuchtungseinrichtung anhand von Ausführungsbeispielen und den dazu gehörigen Figuren näher erläutert.

In den Ausführungsbeispielen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelnen Elemente zum besseren Verständnis übertrieben groß dargestellt sein.

Figur 1 zeigt eine schematische Schnittdarstellung einer Leuchtdiode mit Leuchtdiodenoptik gemäß eines ersten Ausführungsbeispiels der Leuchtdiode.

Figur 2 zeigt eine schematische Skizze zur Erläuterung der Funktionsweise eines nicht abbildenden optischen Konzentrators.

Figur 3 zeigt eine schematische Schnittdarstellung einer Leuchtdiodenoptik gemäß eines zweiten Ausführungsbeispiels der Leuchtdiode.

Figur 4a zeigt eine perspektivische Ansicht einer Leuchtdiode gemäß eines dritten Ausführungsbeispiels der Leuchtdiode.

Figur 4b zeigt eine perspektivische Darstellung des dritten Ausführungsbeispiels der Leuchtdiode mit Leuchtdiodenoptik.

Figur 5a zeigt eine perspektivische Seitenansicht eines ersten Ausführungsbeispiels der Beleuchtungseinrichtung.

Figur 5b zeigt eine perspektivische Frontalansicht des ersten Ausführungsbeispiels der Beleuchtungseinrichtung.

Figur 6a zeigt eine perspektivische Seitenansicht eines zweiten Ausführungsbeispiels der Beleuchtungseinrichtung.

Figur 6b zeigt eine perspektivische Frontalansicht des zweiten Ausführungsbeispiels der Beleuchtungseinrichtung.

Figur 7a zeigt eine perspektivische Seitenansicht eines dritten Ausführungsbeispiels der Beleuchtungseinrichtung.

Figur 7b zeigt eine perspektivische Frontalansicht des dritten Ausführungsbeispiels der Beleuchtungseinrichtung.

Figur 8a zeigt eine perspektivische Seitenansicht einer beispielhaften Beleuchtungseinrichtung, welche nicht Teil der vorliegenden Erfindung ist.

Figur 8b zeigt eine perspektivische Frontalansicht dieser beispielhaften Beleuchtungseinrichtung.

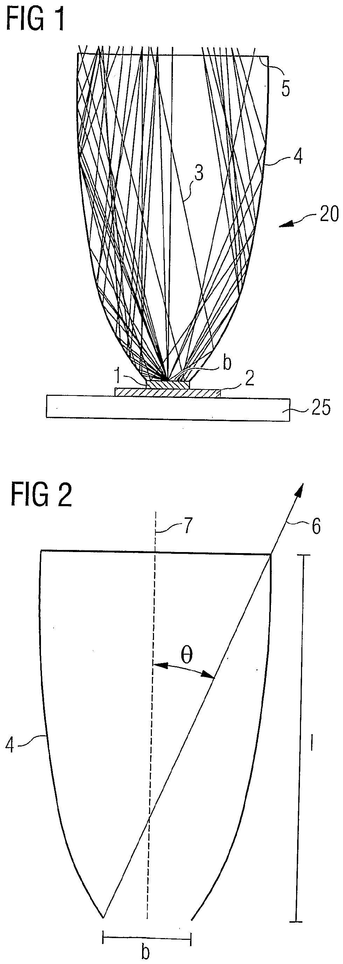

Figur 1 zeigt eine schematische Schnittdarstellung einer Leuchtdiode 20 mit einer Leuchtdiodenoptik 4 gemäß eines ersten Ausführungsbeispiels der Leuchtdiode 20.

Der Leuchtdiodenchip 1 ist hier auf einen Träger 2 aufgebracht. Der Träger 2 kann beispielsweise ein keramisches Material enthalten. Zum Beispiel weist der Träger 2 Durchkontaktierungen zur Kontaktierung des Leuchtdiodenchips 1 auf. Im gezeigten Ausführungsbeispiel ist der Träger 2 auf eine Leiterplatte 25 aufgebracht. Die Leiterplatte 25 weist beispielsweise Leiterbahnen und Kontaktstellen zur Kontaktierung des Leuchtdiodenchips 1 auf.
Der Leuchtdiodenchip 1 ist beispielsweise ein Dünnfilm-Leuchtdiodenchip, wie er im allgemeinen Teil der Beschreibung erläutert ist.

Dem Leuchtdiodenchip 1 ist eine Leuchtdiodenoptik 4 nachgeordnet, bei der es sich beispielsweise um einen dreidimensionalen CPC-artigen, nicht abbildenden optischen Konzentrator handeln kann. Die Leuchtdiodenoptik 4 weist eine Lichteingangsöffnung b auf, durch die vom Leuchtdiodenchip 1 emittierte elektromagnetische Strahlung 3 treten kann. Die elektromagnetische Strahlung 3 wird zumindest teilweise an den Seitenwänden der Leuchtdiodenoptik 4 reflektiert, die dazu bevorzugt mit einer reflektierenden Beschichtung versehen sind. Die Strahlung 3 verlässt die Leuchtdiodenoptik dann durch die Strahlungsaustrittsöffnung 5.

Je näher die Strahlungseintrittsöffnung b der Leuchtdiodenoptik 4 an die Strahlungsauskoppelfläche des Leuchtdiodenchips 1 gebracht wird, desto kleiner kann die Strahlungseintrittsöffnung b gestaltet sein und desto höher ist die Strahldichte (Etendue) der durch die Strahlungsaustrittsöffnung 5 austretenden elektromagnetischen Strahlung 3. Leuchtdiodenoptik 4 und Leuchtdiodenchip 1 bilden zusammen die Leuchtdiode 20.

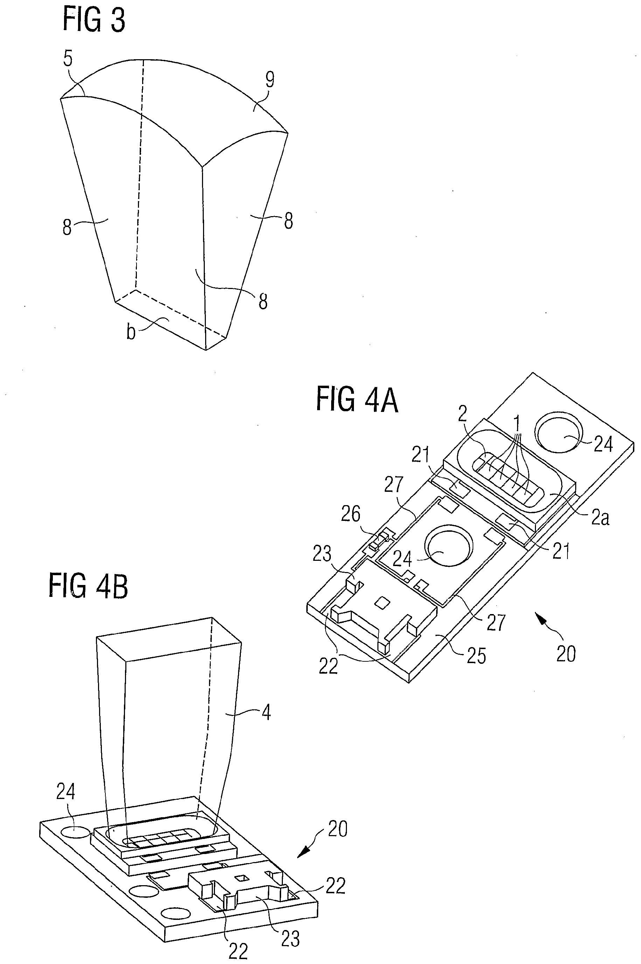

Alternativ zum in Figur 1 gezeigten Ausführungsbeispiel ist es möglich, dass mehrere Leuchtdiodenchips beispielsweise entlang einer Geraden auf dem Träger 2 angeordnet sind und diesen Leuchtdiodenchips eine gemeinsame Leuchtdiodenoptik 4 zugeordnet ist (siehe auch Figuren 4a und 4b).

Figur 2 zeigt, dass der Strahlkegel 6 der durch die Leuchtdiodenoptik 4 tretenden Strahlung die Strahlungsaustrittsöffnung 5 mit einem maximalen Winkel θ zu einer Mittelachse 7 der Leuchtdiodenoptik 4 verlässt. Die Länge 1 der Leuchtdiodenoptik 4 bestimmt dabei bei gegebener Breite der Strahlungseintrittsöffnung b den Winkel θ. Für einen idealen kompakten parabolischen Konzentrator ergibt sich beispielsweise folgender Zusammenhang:

$$l = \frac{b}{2}(1 + \sin\theta)\frac{\cos\theta}{\sin^2\theta}.$$

Um einen maximalen Öffnungswinkel von beispielsweise θ= 9° zu erreichen, muss die Länge 1 der Leuchtdiodenoptik etwa 23 Mal so groß wie die Breite der Strahlungseintrittsöffnung b sein.

Figur 3 zeigt, dass alternativ zu einem CPC-artigen optischen Konzentrator die Leuchtdiodenoptik auch Seitenwände 8 aufweisen kann, die in geraden Linien von der Strahlungseintrittsöffnung b zur Strahlungsaustrittsöffnung 5 verlaufen. Dabei kann die Leuchtdiodenoptik 4 ein Vollkörper aus einem dielektrischen Material sein, der eine kegelstumpf- oder pyramidenstumpfartige Grundform aufweist. Zusätzlich kann die Strahlungsaustrittsöffnung 5 nach Art einer sphärischen oder asphärischen Linse nach außen gewölbt sein, die eine zusätzliche Leuchtdiodenoptik 9 bildet, das Teil der Leuchtdiodenoptik ist, und geeignet ist, die Divergenz der durch das optische Element 4 tretenden Strahlung 3 zu verringern.

Figur 4a zeigt eine perspektivische Ansicht der Leuchtdiode 20 gemäß eines dritten Ausführungsbeispiels der Leuchtdiode 20.

In diesem Ausführungsbeispiel ist eine Vielzahl von Leuchtdiodenchips 1 auf einem Träger 2 entlang einer Linie angeordnet. Bevorzugt sind vier oder fünf Leuchtdiodenchips auf dem Träger 2 angeordnet.

Der Träger 2 weist zudem Innenwände 2a auf, die den Leuchtdiodenchips 1 nachgeordnet sind. Bevorzugt sind die Innenwände 2a geeignet, die von den Leuchtdiodenchips 1 emittierte Strahlung zu reflektieren. Dazu enthalten die Trägerinnenwände 2a entweder ein reflektierendes Material oder sind reflektierend beschichtet. Die Innenwände 2a des Trägers bilden die Leuchtdiodenoptik 4 oder sind Teil der Leuchtdiodenoptik 4. Beispielsweise können die Innenwände 2a nach Art eines nicht abbildenden optischen Konzentrats geformt sein, wie er weiter oben beschrieben ist.

Der Träger 2 ist auf eine Leiterplatte 25 montiert, bei der es sich beispielsweise um eine Metallkernplatine handelt.

Der Träger 2 weist weiter Kontaktflächen 21 auf, über die die Leuchtdiodenchips 1 elektrisch kontaktiert werden können. Mittels Leiterbahnen 27 auf der Leiterplatte 25 sind die Kontaktflächen 21 mit elektrischen Außenkontaktflächen 22 verbunden. Mittels eines Gegensteckers 23 können die Außenkontaktflächen 22 über eine einfache Steckverbindung von außen kontaktiert werden. Zusätzlich kann den Leuchtdiodenchips 1 wenigstens ein Varistor 26 parallel geschaltet sein, der als Überspannungsschutz für die Leuchtdiodenchips 1 fungiert. Weiter kann die Leiterplatte 25 Ausnehmungen 24 aufweisen, die zur Aufnahme von Passstiften geeignet sind. In dem gezeigten Ausführungsbeispiel sind die Ausnehmungen 24 durch Passbohrungen gegeben.

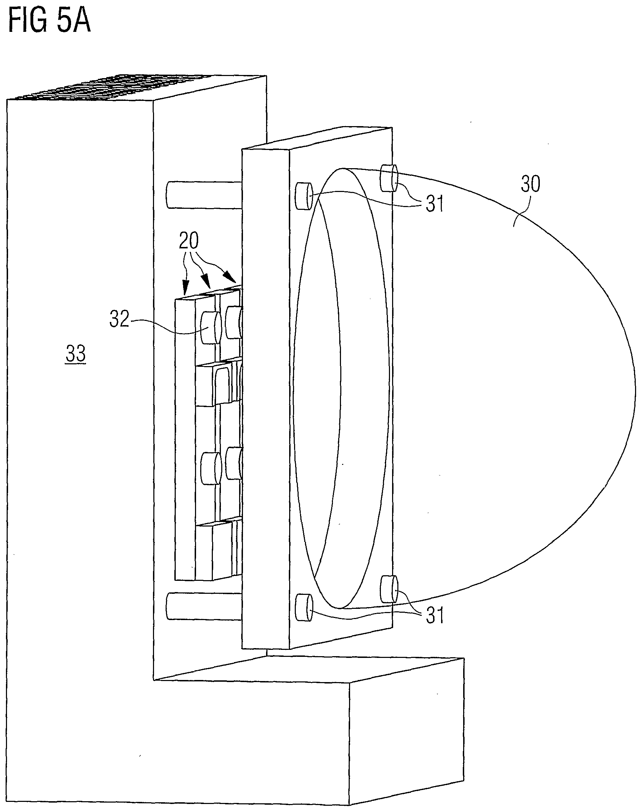

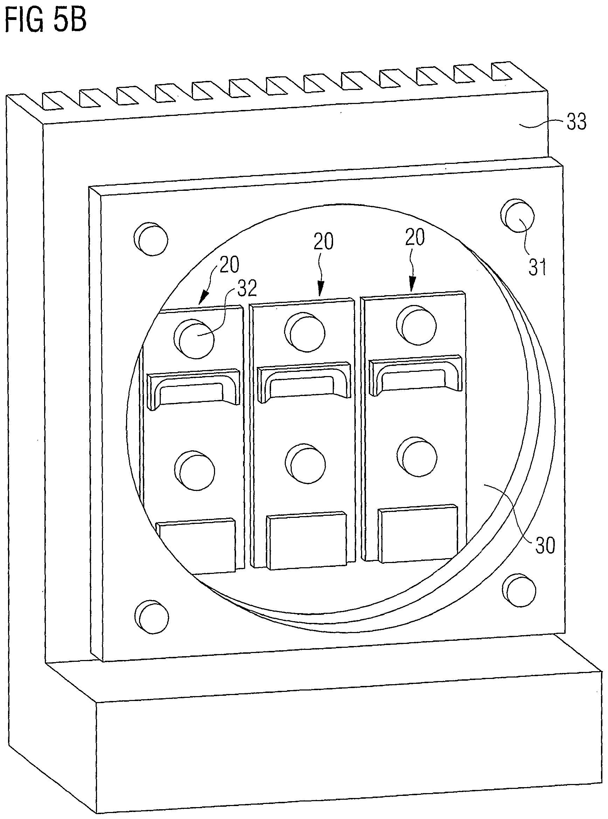

Figur 5a zeigt eine perspektivische Seitenansicht eines ersten Ausführungsbeispiels der hier beschriebenen Beleuchtungseinrichtung. Figur 5b zeigt die dazugehörige Frontalansicht.

Mehrere Leuchtdiodenchips 20, wie sie beispielsweise in den Figuren 1, 3 oder 4 beschrieben sind, sind hier auf einen Träger 33 montiert. Der Träger 33 dient vorzugsweise auch als Kühlkörper für die im Betrieb von den Leuchtdioden 20 erzeugte Wärme. Der Träger 33 weist dazu an seiner den Leuchtdioden 20 abgewandten Oberfläche Kühlrippen auf. Der Träger 33 enthält bevorzugt ein gut wärmeleitendes Metall wie beispielsweise Kupfer.

Die Leuchtdioden 20 - in diesem Ausführungsbeispiel drei Leuchtdioden - und der Träger 33 sind mittels Passstiften 32 zueinander justiert sein. Auf diese Weise sind auch die Leuchtdioden 20 zueinander justiert. Bei den Passstiften 32 kann es sich um separate Bauteile handeln. Träger 33 und Leuchtdiode 20 weisen dann Ausnehmungen, beispielsweise Passbohrungen, auf. Die Passbohrungen an Träger 33 und Leuchtdiode 20 weisen einen Durchmesser auf, sodass die Passstifte 32 bündig in die Passbohrungen greifen.

Zudem ist es möglich, dass die Passstifte integraler Bestandteil des Trägers 33 sind. Das heißt, die Passstifte sind mechanisch fest mit dem Träger 33 verbunden. Dies kann beispielsweise schon bei der Herstellung des Trägers 33 geschehen. Die Leiterplatte 25 der Leuchtdiode 20 weist dann Ausnehmungen 24 auf, die zur Aufnahme dieser Passstifte geeignet sind.

Ebenso ist es möglich, dass die Passstifte 32 integraler Bestandteil der Leuchtdiode 20 sind. Im Träger 33 sind dann Ausnehmungen zur Aufnahme dieser Passstifte vorgesehen.

Den Leuchtdioden 2 ist in diesem Ausführungsbeispiel der Beleuchtungseinrichtung ein gemeinsames optisches Element 30 nachgeordnet. Das optische Element 30 ist beispielsweise eine diffraktive oder refraktive Linse, die allen Leuchtdioden 20 der Beleuchtungseinrichtung nachgeordnet ist, sodass das von allen Leuchtdioden 20 emittierte Licht durch das optische Element 30 beeinflusst wird.

Das optische Element 30 und der Träger 33 sind mittels Passstiften 31 zueinander justiert. Auf diese Weise sind auch die Leuchtdioden 20 und das optische Element 30 zueinander justiert.

Die Passstifte 1 können separate Bauteile sein. Es ist aber auch möglich, dass die Passstifte 31 integraler Bestandteil von Träger 33 oder optischem Element 30 sind. Das jeweils andere Bauteil weist dann Ausnehmungen - z.B. Passbohrungen - auf, die zur Aufnahme der Passstifte 31 geeignet sind.

Nach der Justage von Leuchtdioden 20 und Träger 33 und der Justage von optischem Element 30 und Träger 33 zueinander werden die Leuchtdioden 20 mechanisch fest mit dem Träger verbunden. Beispielsweise können die Leuchtdioden 20 mit dem Träger 33 verklebt, verschraubt oder verstemmt sein. Auch das optische Element 30 wird vorzugsweise nach dem Justagevorgang mechanisch fest mit dem Träger 33 verbunden.

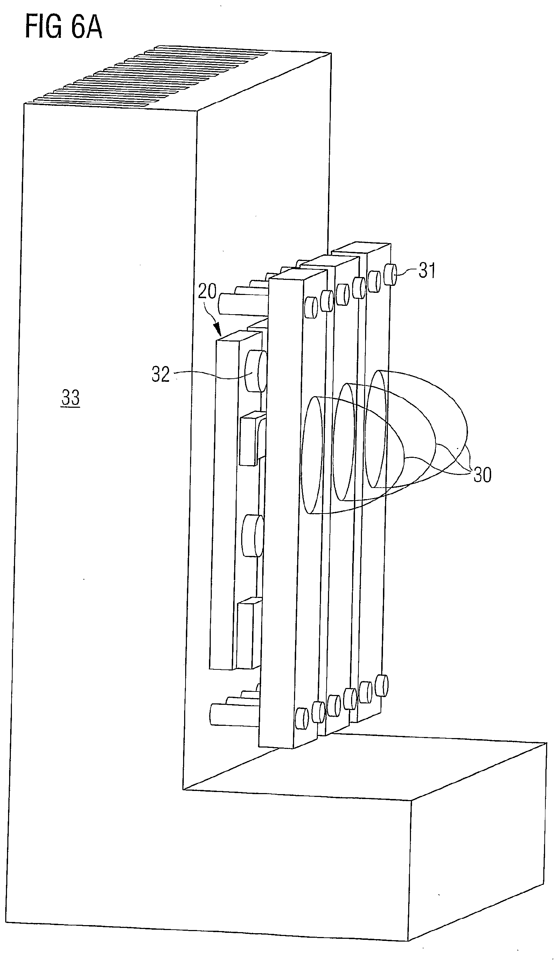

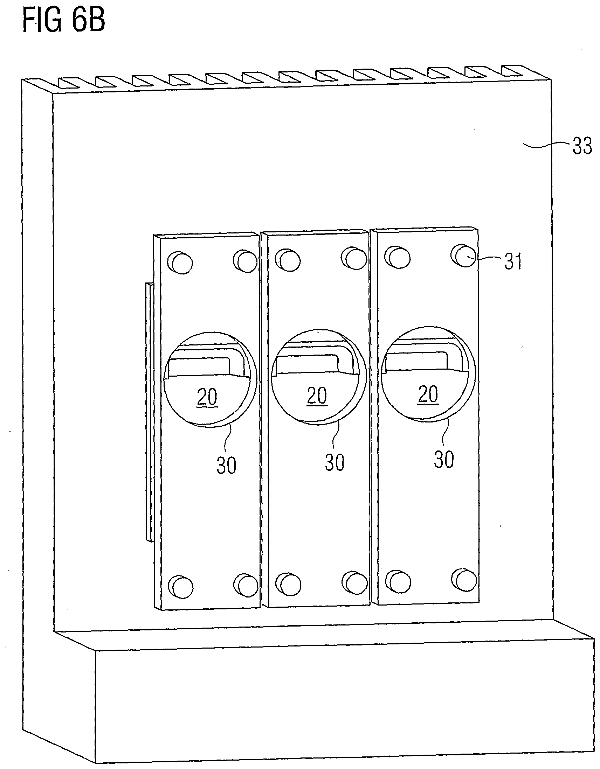

Figur 6a zeigt eine perspektivische Seitenansicht eines zweiten Ausführungsbeispiels der Beleuchtungseinrichtung. Figur 6b zeigt die dazugehörige Frontalansicht.

Im Gegensatz zu den in den Figuren 5a und 5b gezeigten Ausführungsbeispielen ist hier jeder Leuchtdiode 20 ein optisches Element 30 eineindeutig zugeordnet. Bei den Optiken 30 handelt es sich beispielsweise um refraktive oder diffraktive Linsen. Die Optiken 30 und der Träger 33, auf dem die Leuchtdioden 20 befestigt sind, sind wiederum mittels Passstiften 32 zueinander justiert.

Weiter kann den Optiken 30 ein weiteres gemeinsames optisches Element nachgeordnet sein (nicht gezeigt), sodass das Gesamtsystem als Zweistufenoptik ausgelegt ist. Die Justage der zusätzlichen, gemeinsamen Optik zum Träger 33 kann mittels Passstiften oder eines optischen Bildverarbeitungssystems erfolgen. Bei der zusätzlichen Optik handelt es sich beispielsweise um eines der folgenden optischen Elemente: diffraktive Optik, refraktive Optik, reflektive Optik, holographische Optik.

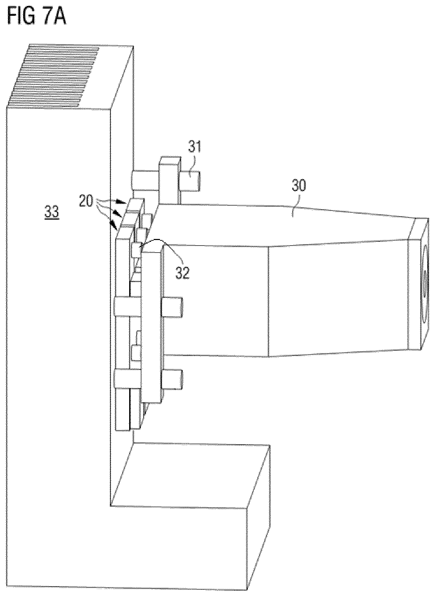

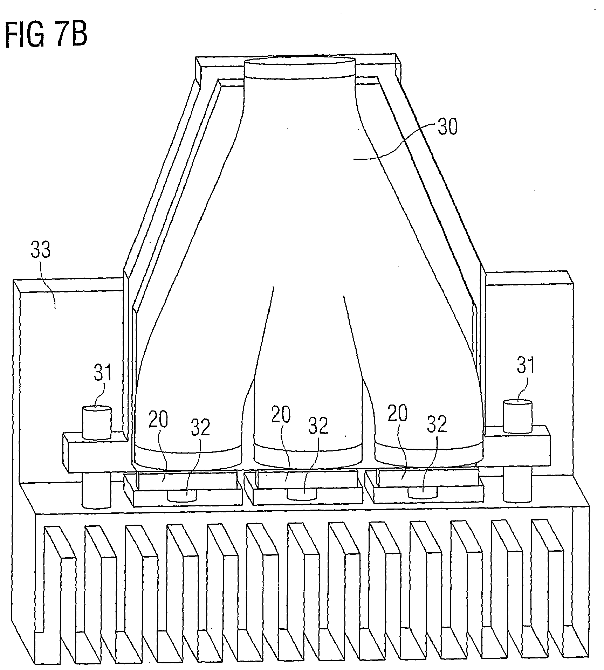

Figur 7a zeigt eine perspektivische Seitenansicht eines dritten Ausführungsbeispiels der hier beschriebenen Beleuchtungseinrichtung. Figur 7b zeigt die dazugehörige Frontalansicht.

Im Gegensatz zu dem Ausführungsbeispiel der Figuren 6a und 6b ist den Leuchtdioden 20 hier eine Faseroptik 30 nachgeordnet. Bei der Faseroptik 30 koppelt das von den Leuchtdiodenchips 1 erzeugte Licht in Fasern des Lichtleitersystems ein. Bevorzugt koppelt jeder Leuchtdiodenchip 1 Licht in genau eine dem Leuchtdiodenchip 1 eineindeutig zugeordnete Faser der Faseroptik ein. Die Faseroptik 30 und der Träger 33 können wiederum mittels Passstiften 32 und entsprechenden Passbohrungen zueinander justiert sein.

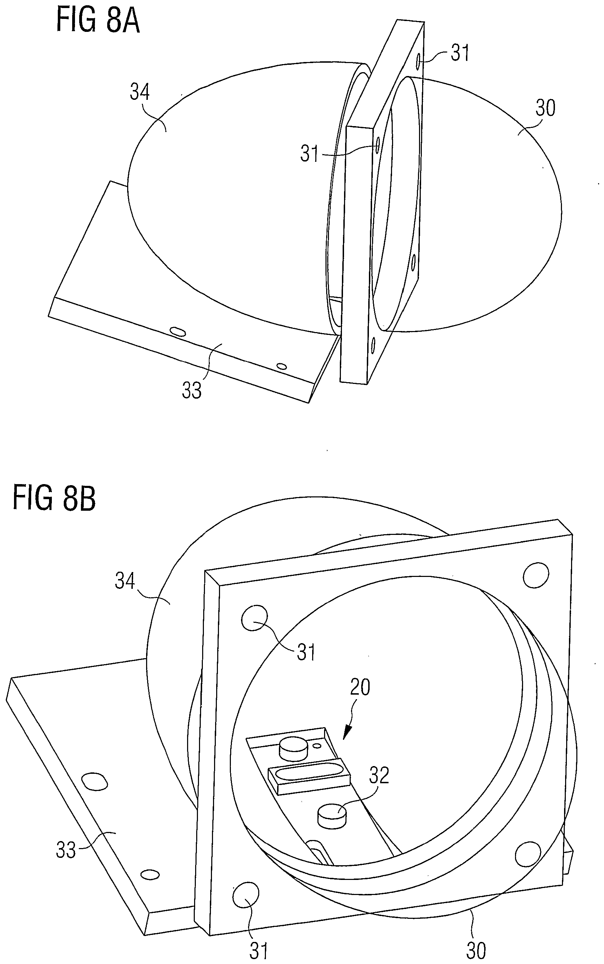

Figur 8a zeigt eine perspektivische Seitenansicht einer beispielhaften Beleuchtungseinrichtung. Figur 8b zeigt die dazugehörige Frontalansicht.

In diesem Beispiel ist wenigstens eine Leuchtdiode 20 direkt in einen Reflektor 34 montiert. Bevorzugt sind mehrere Leuchtdioden 20 in den Reflektor 34 montiert. Beispielsweise weisen die Leuchtdioden 20 Passbohrungen auf. Die Leuchtdioden 20 werden dann mittels Passstiften 32 zum Reflektor 34 justiert. Zusätzlich kann der Reflektor 34 mittels der Passstiften zu einem Träger 33 justiert sein.

An den Reflektor 34 kann ein zusätzliches optisches Element 30 montiert sein. Beim zusätzlichen optischen Element 30 kann es sich beispielsweise um ein refraktives oder diffraktives optisches Element handeln. Das optische Element 30 kann mittels Passstiften 31 zum Reflektor und damit den im Reflektor befestigten Leuchtdioden 20 justiert sein.

In allen Ausführungsbeispiel ist es möglich, dass zumindest ein Leuchtdiodenchip der Leuchtdioden 20 geeignet ist, elektromagnetische Strahlung im nahen Infrarotbereich zu emittieren. Die vom Infrarot-Leuchtdiodenchip emittierte Strahlung kann zum Beispiel unter Verwendung eines optischen Detektors in einem Nachtsichtgerät eine Kraftfahrzeugs Verwendung finden. Als Detektor kann zum Beispiel eine Photodiode im Frontbereich des Kraftfahrzeugs angebracht sein. Beispielsweise ist die Photodiode auf den Träger 33 befestigt und kontaktiert. Der Rotlichtanteil der vom Infrarot-Leuchtdiodenchip emittierten Strahlung kann zur Erhöhung des Farbwidergabewertes des von den Leuchtdioden 20 emittierten weißen Lichts dienen.

**Patentansprüche**

1. Kfz-Scheinwerfer, aufweisend zumindest eine Beleuchtungseinrichtung mit

   - einem Träger (33)
   - wenigstens einer Leuchtdiode (20), die mittels wenigstens eines Passstifts (32) zu dem Träger (33) justiert und mit diesem verbunden ist, und
   - wenigstens einem optischen Element (30), das mittels wenigstens eines weiteren Passstifts (31) zu dem Träger (33) justiert und mit diesem verbunden ist,
   wobei
   - Leuchtdiode (20) und optisches Element (30) mittels der Passstifte (31, 32) zueinander justiert sind, und
   - der Träger (33) als Kühlkörper für die im Betrieb von der Leuchtdiode (20) erzeugte Wärme dient, wobei der Träger (33) an seiner der Leuchtdiode (20) abgewandten Oberfläche Kühlrippen aufweist.

2. Kfz-Scheinwerfer nach Anspruch 1,
   bei dem jeder Leuchtdiode (20) genau ein optisches Element (30) nachgeordnet ist.

3. Kfz-Scheinwerfer nach Anspruch 1 oder 2,
   bei dem mehreren Leuchtdioden (20) ein gemeinsames optisches Element (30) nachgeordnet ist.

4. Kfz-Scheinwerfer nach einem der Ansprüche 1 bis 3,
   bei dem das optische Element (30) zumindest teilweise durch eine Faseroptik gebildet ist.

5. Kfz-Scheinwerfer nach Anspruch 4,
   bei dem das von einem Leuchtdiodenchip (1) emittierte Licht in genau eine Faser der Faseroptik eingekoppelt wird.

6. Kfz-Scheinwerfer nach einem der vorhergehenden Ansprüche,
   bei dem die Leuchtdiode (20) wenigstens einen Leuchtdiodenchip (1) aufweist, dem eine Leuchtdiodenoptik (4) nachgeordnet ist.

7. Kfz-Scheinwerfer nach Anspruch 6,
   bei dem die Leuchtdiodenoptik (4) zur Verringerung der Divergenz des vom Leuchtdiodenchip (1) emittierten Lichts (3) geeignet ist.

8. Kfz-Scheinwerfer nach Anspruch 6 oder 7,
   bei dem die Leuchtdiodenoptik (4) ein nicht abbildender optischer Konzentrator ist.

9. Kfz-Scheinwerfer nach Anspruch 8,
   bei dem die Leuchtdiodenoptik (4) zumindest teilweise nach Art wenigstens eines der folgenden optischen Elemente gebildet ist: CPC, CEC, CHC, Pyramidenstumpf, Kegelstumpf.

10. Kfz-Scheinwerfer nach einem der Ansprüche 6 bis 9,
    bei dem die Leuchtdiodenoptik (4) eine Strahlungseingangsöffnung (b) aufweist, die maximal zweimal so groß ist wie die Gesamtstrahlungsauskoppelfläche der Leuchtdiodenchips (1) der Leuchtdiode (20).

11. Kfz-Scheinwerfer nach einem der 6 bis 10,
    bei dem wenigstens ein Leuchtdiodenchip (1) ein Dünnfilmleuchtdiodenchip ist.

12. Verfahren zur Herstellung eines Kfz-Scheinwerfers, aufweisend mindestens eine Beleuchtungseinrichtung mit wenigstens einer Leuchtdiode (20), wobei die Leuchtdiode (20) mittels wenigstens eines Passstifts (32) zu einem Träger (33) justiert und mit diesem verbunden wird, und mit wenigstens einem optischen Element (30), das mittels wenigstens eines weiteren Passstifts (31) zu dem Träger (33) justiert und mit diesem verbunden wird,
    wobei

    - das optisches Element (30) und die Leuchtdiode (20) mittels der Passstifte (31) zueinander justiert werden, und
    - der Träger (33) als Kühlkörper für die im Betrieb von der Leuchtdiode (20) erzeugte Wärme dient, wobei der Träger (33) an seiner der Leuchtdiode (20) abgewandten Oberfläche Kühlrippen aufweist.

**Claims**

1. Vehicle headlamp, comprising at least one lighting device with

   - a carrier (33)
   - at least one light-emitting diode (20), which is adjusted to the carrier (33) by means of at least one dowel pin (32) and is connected thereto, and
   - at least one optical element (30), which is adjusted to the carrier (33) by means of at least one further dowel pin (31) and is connected thereto,
   wherein
   - light-emitting diode (20) and optical element (30) are adjusted with respect to one another by means of the dowel pins (31, 32), and
   - the carrier (33) serves as a heat sink for the heat generated during operation by the light-emitting diode (20), wherein the carrier (33) has cooling fins on its surface facing away from the light-emitting diode (20).

2. Vehicle headlamp according to claim 1, in which exactly one optical element (30) is arranged downstream of each light-emitting diode (20).

3. Vehicle headlamp according to claim 1 or 2, in which a common optical element (30) is arranged downstream of a plurality of light-emitting diodes (20).

4. Vehicle headlamp according to one of the claims 1 to 3, in which the optical element (30) is formed at least partially by a fiber optic.

5. Vehicle headlamp according to claim 4, in which the light emitted by a light emitting diode chip (1) is coupled-in into exactly one fiber of the fiber optics.

6. Vehicle headlamp according to one of the preceding claims, in which the light-emitting diode (20) has at least one light-emitting diode chip (1), to which a light-emitting diode optical system (4) is arranged downstream.

7. Vehicle headlamp according to claim 6, in which the light emitting diode optical system (4) is suitable for reducing the divergence of the light (3) emitted by the light emitting diode chip (1).

8. Vehicle headlamp according to claim 6 or 7, in which the light emitting diode optical system (4) is a non-imaging optical concentrator.

9. Vehicle headlamp according to claim 8, in which the light-emitting diode optical system (4) is formed at least partially in the manner of at least one of the following optical elements: CPC, CEC, CHC, truncated pyramid, truncated cone.

10. Vehicle headlamp according to one of the claims 6 to 9, in which the light emitting diode optics (4) has a radiation input opening (b), which is at most twice as large as the total radiation coupling-out area of the light emitting diode chips (1) of the light emitting diode (20).

11. Vehicle headlamp according to one of the claims 6 to 10, wherein at least one light emitting diode chip (1) is a thin film light emitting diode chip.

12. Method for producing a vehicle headlamp, having at least one lighting device with at least one light-emitting diode (20), wherein the light-emitting diode (20) is adjusted to a carrier (33) by means of at least one dowel pin (32) and is connected thereto, and at least one optical element (30), which is adjusted to the carrier (33) by means of at least one further dowel pin (31) and is connected thereto, wherein

    - the optical element (30) and the light-emitting diode (20) are adjusted with respect to one another by means of the dowel pins (31), and
    - the carrier (33) serves as a heat sink for the heat generated during operation by the light-emitting diode (20), wherein the carrier (33) has cooling fins on its surface facing away from the light-emitting diode (20).

**Revendications**

1. Phare de voiture, comprenant au moins un dispositif d'éclairage comportant

   - un support (33),
   - au moins une diode électroluminescente (20) étant ajustée à l'aide d'au moins une goupille (32) par rapport au support (33) en étant connecté à celui-ci, et
   - au moins un élément optique (30) étant ajusté à l'aide d'au moins une autre goupille (31) par rapport au support (33) en étant connecté à celui-ci,
   - la diode électroluminescente (20) et l'élément optique (30) étant ajustées à l'aide des goupilles (31) par rapport à l'autre, et
   - le support (33) servant d'élément de refroidissement pour la chaleur générée par la diode électroluminescente (20) pendant le service, le support (33) comportant des ailettes de refroidissement sur sa face opposée à la diode électroluminescente (20).

**2.** Phare de voiture selon la revendication 1, dans lequel précisément un élément optique (30) est disposé en aval de chaque diode électroluminescente (20).

**3.** Phare de voiture selon la revendication 1 ou 2, dans lequel un élément optique (30) commun est disposé en aval de plusieurs diodes électroluminescentes (20).

**4.** Phare de voiture selon l'une quelconque des revendications 1 à 3, dans lequel l'élément optique (30) est constitué au moins en partie par des fibres optiques.

**5.** Phare de voiture selon la revendication 4, dans lequel la lumière émise par une puce à diode électroluminescente (1) est couplée dans précisément une fibre des fibres optiques.

**6.** Phare de voiture selon l'une quelconque des revendications précédentes, dans lequel la diode électroluminescente (20) comporte au moins une puce à diode électroluminescente (1), à laquelle une optique à diode électroluminescente (4) est disposée en aval.

**7.** Phare de voiture selon la revendication 6, dans lequel l'optique à diode électroluminescente (4) est apte à réduire la divergence de la lumière émise par la puce à diode électroluminescente (1).

**8.** Phare de voiture selon la revendication 6 ou 7, dans lequel l'optique à diode électroluminescente (4) est un concentrateur optique non-imageur.

**9.** Phare de voiture selon la revendication 8, dans lequel l'optique à diode électroluminescente (4) est au moins en partie du type d'au moins un des éléments optiques suivants : CPC, CEC, CHC, tronc de pyramide, tronc de cône.

**10.** Phare de voiture selon l'une quelconque des revendications 6 à 9, dans lequel l'optique à diode électroluminescente (4) présente une ouverture d'entrée de rayonnement (b) qui est au maximum deux fois plus grande que la surface totale de découplage de rayonnement des puces à diode électroluminescente (1) de la diode électroluminescente (20).

**11.** Phare de voiture selon l'une quelconque des revendications 6 à 10, dans lequel au moins une puce à diode électroluminescente (1) est une puce à diode électroluminescente à couche mince.

**12.** Procédé de fabrication d'un phare de voiture, comportant au moins un dispositif d'éclairage comprenant au moins une diode électroluminescente (20), la diode électroluminescente (20) étant ajustée à l'aide d'au moins une goupille (32) par rapport au support (33) en étant connecté à celui-ci, et comprenant au moins un élément optique (30) étant ajusté à l'aide d'au moins une autre goupille (31) par rapport au support (33) en étant connecté à celui-ci,

- l'élément optique (30) et la diode électroluminescente (20) étant ajustées à l'aide des goupilles (31) par rapport à l'autre, et
- le support (33) servant d'élément de refroidissement pour la chaleur générée par la diode électroluminescente (20) pendant le service, le support (33) comportant des ailettes de refroidissement sur sa face opposée à la diode électroluminescente (20).

## FIG 1

## FIG 2

FIG 3

FIG 4A

FIG 4B

## FIG 5A

FIG 5B

## FIG 6A

## FIG 6B

FIG 7A

FIG 7B

FIG 8A

FIG 8B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20040184737 A
- US 20030156416 A1
- WO 9812757 A

**In der Beschreibung aufgeführte Nicht-Patentliteratur**

- **DRUCKSCHRIFT I. SCHNITZER et al.** *Appl. Phys. Lett.,* 18. Oktober 1993, vol. 63 (16), 2174-2176